# EUROPEAN PATENT SPECIFICATION

(11) **EP 1 762 855 B1**
(45) Date of publication and mention of the grant of the patent: **24.12.2008**
(21) Application number: 05019689.8
(22) Date of filing: 09.09.2005
(51) Int. Cl.: G01R 31/3185

(54) **JTAG port**
JTAG Port
Porte JTAG

(43) Date of publication of application: 14.03.2007
(73) Proprietor: Infineon Technologies AG, 81669 München (DE)
(72) Inventor: Lewis, Michael, 195 52 Märsta (SE)
(74) Representative: Graf Lambsdorff, Matthias

(56) References cited:
- EP-A- 0 969 290
- GB-A- 2 379 524
- US-A- 5 889 787

## Description

### Field of invention

The present invention relates to a method for an integrated circuit comprising a JTAG scan test interface, and a first pin, which first pin provides the possibility to control the use of the JTAG interface, so that when a JTAG# signal at the first pin is at a first state, the JTAG interface is connected to a first set of pins for testing purposes, and when the JTAG# signal is at a second state, the first set of pins are available for other functions and purposes. The present invention also relates to an integrated circuit.

### Description of the background art

On a typical integrated circuit, a JTAG scan test interface is provided. This allows for production test of the device at the wafer level as it is being fabricated, and subsequent in-circuit testing of the device to verify correct assembly. The interface consists of clock TCK, data input TDI, data output TDO, and test reset TRST#. Additionally, the pin JTAG# is used to indicate that the JTAG interface is active.

Modern ultra-miniature device packaging technologies put great pressure on the number of available pins. For this reason, it is typically possible to multiplex the function of the JTAG interface pins. When the JTAG# signal is high, the JTAG interface is connected to the assigned pins. When the JTAG# signal is low, these pins can be used for other functions. However, it is not possible to use the JTAG# signal for another purpose.

EP-A-0 969 290 (WaferScale Integration Inc., 5 January 2000) discloses a memory chip with selectively configurable four pins to communicate JTAG data to the JTAG controller or to communicate non-JTAG data to an internal function.

### Summary of the present invention

The purpose of the present invention is to allow the JTAG# pin to also be shared with another function.

The present invention teaches that the JTAG interface controller is adapted to generate a JTAG enable signal. A first switch, belonging to the integrated circuit, is adapted to switch the connection of the first pin between two functions, which first switch is adapted to connect the JTAG# signal to the first pin when the JTAG enable signal is at a first state, and to connect the first pin to other functions and purposes when the JTAG enable signal is at a second state.

The first switch may be adapted to receive the JTAG enable signal from a non-volatile storage element belonging to the integrated circuit, and the JTAG interface controller may be adapted to control the non-volatile storage element. This non-volatile storage element may for instance be an eFuse or a laser fuse.

For the purpose of providing a possibility to complete the programming and testing of the integrated circuit in a stable manner it is proposed that the first switch is adapted to read a new state of the JTAG enable signal only on power-on reset.

### Brief description of the drawings.

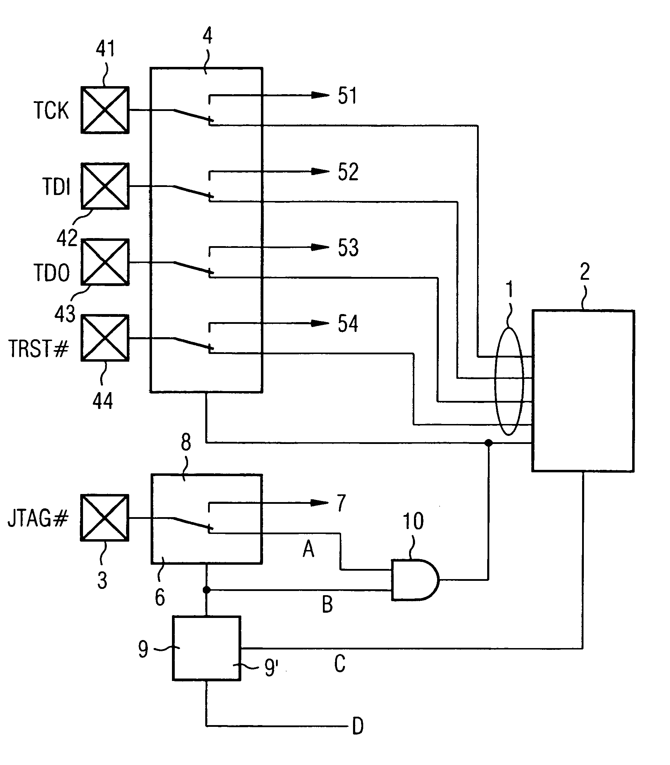

A method and an integrated circuit according to the present invention will now be described in more detail with reference to the accompanying drawings, in which figure 1 is a schematic and simplified illustration of an inventive JTAG scan test interface.

### Description of embodiments as presently preferred

Figure 1 illustrates a method for an integrated circuit, and an integrated circuit, comprising a JTAG scan test interface 1, a JTAG interface controller 2 and a first pin 3, where each of the pins used by the JTAG interface 1 is connected to a pad multiplexing block 4, shown schematically as switches.

The first pin 3 provides the possibility to control the use of the JTAG interface 1, so that when a JTAG# signal A at the first pin 3 is at a first state, the JTAG interface 1 is connected to a first set of pins 41, 42, 43, 44 for testing purposes, and when the JTAG# signal A is at a second state, the first set of pins 41, 42, 43, 44 are available for other functions and purposes 51, 52, 53, 54.

The pad multiplexing block 6 for the first pin 3 is controlled by a JTAG enable signal B. An inventive method comprises the steps of:
- generating the JTAG enable signal B,
- connecting the JTAG# signal A to the first pin 3 when the JTAG enable signal B is at a first state, and
- making the first pin 3 available for other functions and purposes 7 when the JTAG enable signal B is at a second state.

The present invention proposes that a first switch 8 is adapted to switch the first pin 3 between the JTAG# signal A and the other functions and purposes 7.

The JTAG enable signal B is preferably coming from a non-volatile storage element 9 belonging to the integrated circuit, which non-volatile storage element 9 is controlled by the JTAG interface controller 2.

The non-volatile storage element 9 may be an eFuse 9' belonging to the integrated circuit, which would make it possible for the JTAG interface controller 2 to programme the eFuse 9' by passing a programming current C through it.

This means that when the eFuse 9' is not blown, the JTAG# signal A is selected and when the eFuse 9' has been blown, the alternative function 7 for the first pin 3 is enabled by the first switch 8.

The JTAG# signal A may be ANDed 10 with the JTAG enable signal B, and this combined signal is used to enable the JTAG interface 1 and to select the function of the other JTAG interface pins.

One proposed embodiment of the present invention teaches that a new state of the JTAG enable signal B is only read on power-on reset D, which makes it possible to ensure that the service state will not be available after that the eFuse 9' has been blown by the programming current C by blowing the eFuse after completed testing and thereby changing the state of the JTAG enable signal B, then turning the power off and on again, where after all of the JTAG interface pins 41, 42, 43, 44 will be permanently switched over to their alternative function 51, 52, 53, 54.

During production test, evaluation, and assembly in the integrated circuit, the JTAG interface 1 can be used as normal, selected by the JTAG# signal B. When the JTAG interface 1 is no longer required, the eFuse cell 9' is blown, which in the exemplifying embodiment, is performed via the JTAG interface 1. The eFuse cell 9' in this embodiment is enabled such that a new value is only read on power-on reset, which guarantees that the programming can be completed in a stable manner. When the power is removed and then reapplied, all of the JTAG interface pins will be permanently switched over to their alternative function.

It should be understood that the invention is not limited to the use of an eFuse 9' for a non-volatile storage element 9, but that other non-volatile storage elements, such as a laser fuse, may also be used.

The advantage of the eFuse compared to alternative technologies is that it can be programmed when the integrated circuit has been packaged, or even when it is in-circuit.

It will be understood that the invention is not restricted to the aforedescribed and illustrated exemplifying embodiments thereof and that modifications can be made within the scope of the inventive concept as illustrated in the accompanying Claims.

## Claims

1. A method for an integrated circuit comprising a JTAG scan test interface (1), a JTAG interface controller (2) and a first pin (3), the first pin (3) providing the possibility to control the use of the JTAG interface (1) via a control input, so that when a JTAG# signal at the first pin (3) is at a first state, the JTAG interface (1) is connected to a first set of pins (41, 42, 43, 44) for testing purposes, and when the JTAG# signal is at a second state, the first set of pins (41, 42, 43, 44) are available for other functions and purposes (51, 52, 53, 54), **characterised in**,
- generating a JTAG enable signal (B) controlled by the JTAG interface controller (2),
- coupling the first pin (3) to the control input when the JTAG enable signal (B) is at a first state, and
- decoupling the first pin (3) from the control input to be available for other functions and purposes (7) when the JTAG enable signal (B) is at a second state.

2. The method according to claim 1, **characterised in, that** the JTAG enable signal (B) is coming from a non-volatile storage element (9) belonging to the integrated circuit, and that the JTAG interface controller (2) controls the non-volatile storage element (9).

3. The method according to claim 1, **characterised in, that** the JTAG enable signal (B) is generated by an eFuse (9') belonging to the integrated circuit, and that the JTAG interface controller (2) programmes the eFuse (9') by passing a programming current (C) through it.

4. The method according to any preceding claim, **characterised in, that** a new state of the JTAG enable signal (B) is only read on power-on reset.

5. An integrated circuit comprising a JTAG scan test interface (1), a JTAG interface controller (2) and a first pin (3), where it is possible to control the use of the JTAG interface (1) by means of a JTAG# signal at the first pin (3), where the JTAG interface (1) is connected to a first set of pins (41, 42, 43, 44) for testing purposes if the JTAG# signal is at a first state, and where the first set of pins (41, 42, 43, 44) are available for other functions and purposes (51, 52, 53, 54) if the JTAG# signal is at a second state, **characterised in, that** the JTAG interface controller (2) is configured to control the generation of a JTAG enable signal (B), that a first switch (8), belonging to the integrated circuit, is configured to switch the connection of the first pin (3) between two functions, that the first switch (8) is configured to connect the first pin (3) to control the use of the JTAG interface (1) when the JTAG enable signal (B) is at a first state, and that the first switch (8) is configured to connect the first pin (3) to be available for other functions and purposes (7) when the JTAG enable signal (B) is at a second state.

6. The integrated circuit according to claim 5, **characterised in, that** the first switch (8) is configured to receive the JTAG enable signal (B) from a non-volatile storage element (9) belonging to the integrated circuit, and that the JTAG interface controller (2) is configured to control the non-volatile storage element (9).

7. The integrated circuit according to claim 5, **characterised in, that** the first switch (8) is configured to receive the JTAG enable signal (B) from an eFuse (9') belonging to the integrated circuit, and that the JTAG interface controller (2) is configured to programme the eFuse (9') by passing a programming current (C) through it.

8. The integrated circuit according to any one of claims 5 to 7, **characterised in, that** the first switch (8) is configured to read a new state of the JTAG enable signal (B) only on power-on reset.

## Patentansprüche

1. Verfahren für eine integrierte Schaltung mit einer JTAG-Scan-Prüfschnittstelle (1), einem JTAG-Schnittstellen-Controller (2) und einem ersten Pin (3), wobei der erste Pin (3) die Möglichkeit zur Steuerung der Benutzung der JTAG-Schnittstelle (1) über einen Steuereingang bereitstellt, dergestalt daß, wenn sich ein JTAG#-Signal an dem ersten Pin (3) in einem ersten Zustand befindet, die JTAG-Schnittstelle (1) für Prüfzwecke mit einer ersten Menge von Pins (41, 42, 43, 44) verbunden ist, und wenn sich das JTAG#-Signal in einem zweiten Zustand befindet, die erste Menge von Pins (41, 42, 43, 44) für andere Funktionen und Zwecke (51, 52, 53, 54) verfügbar ist, **gekennzeichnet durch**
- Erzeugen eines JTAG-Freigabesignals (B), das durch den JTAG-Schnittstellen-Controller (2) gesteuert wird,
- Koppeln des ersten Pins (3) mit dem Steuereingang, wenn sich das JTAG-Freigabesignal (B) in einem ersten Zustand befindet, und
- Entkoppeln des ersten Pins (3) von dem Steuereingang, um für andere Funktionen und Zwecke (7) verfügbar zu sein, wenn sich das JTAG-Freigabesignal (B) in einem zweiten Zustand befindet.

2. Verfahren nach Anspruch 1, **dadurch gekennzeichnet, daß** das JTAG-Freigabesignal (B) aus einem nichtflüchtigen Speicherelement (9) kommt, das zu der integrierten Schaltung gehört, und daß der JTAG-Schnittstellen-Controller (2) das nichtflüchtige Speicherelement (9) steuert.

3. Verfahren nach Anspruch 1, **dadurch gekennzeichnet, daß** das JTAG-Freigabesignal (B) durch eine zu der integrierten Schaltung gehörenden elektrischen Schmelzsicherung (9') erzeugt wird, und daß der JTAG-Schnittstellen-Controller (2) die elektrische Schmelzsicherung (9') durch Leiten eines Programmierstroms (C) durch sie programmiert.

4. Verfahren nach einem der vorhergehenden Ansprüche, **dadurch gekennzeichnet, daß** ein neuer Zustand des JTAG-Freigabesignals (B) nur bei erneutem Einschalten gelesen wird.

5. Integrierte Schaltung mit einer JTAG-Scan-Prüfschnittstelle (1), einem JTAG-Schnittstellen-Controller (2) und einem ersten Pin (3), wobei es möglich ist, die Benutzung der JTAG-Schnittstelle (1) mittels eines JTAG#-Signals an dem ersten Pin (3) zu steuern, wobei die JTAG-Schnittstelle (1) für Prüfzwecke mit einer ersten Menge von Pins (41, 42, 43, 44) verbunden wird, wenn sich das JTAG#-Signal in einem ersten Zustand befindet, und wobei die erste Menge von Pins (41, 42, 43, 44) für andere Funktionen und Zwecke (51, 52, 53, 54) verfügbar ist, wenn sich das JTAG#-Signal in einem zweiten Zustand befindet, **dadurch gekennzeichnet, daß** der JTAG-Schnittstellen-Controller (2) dafür ausgelegt ist, die Erzeugung eines JTAG-Freigabesignals (B) zu steuern, daß ein zu der integrierten Schaltung gehörender erster Schalter (8) dafür ausgelegt ist, die Verbindung des ersten Pins (3) zwischen zwei Funktionen umzuschalten, daß der erste Schalter (8) dafür ausgelegt ist, den ersten Pin (3) dafür zu verbinden, die Benutzung der JTAG-Schnittstelle (1) zu steuern, wenn sich das JTAG-Freigabesignal (B) in einem ersten Zustand befindet, und daß der erste Schalter (8) dafür ausgelegt ist, den ersten Pin (3) dafür zu verbinden, für andere Funktionen und Zwecke (7) verfügbar zu sein, wenn sich das JTAG-Freigabesignal (B) in einem zweiten Zustand befindet.

6. Integrierte Schaltung nach Anspruch 5, **dadurch gekennzeichnet, daß** der erste Schalter (8) dafür ausgelegt ist, das JTAG-Freigabesignal (B) aus einem zu der integrierten Schaltung gehörenden nichtflüchtigen Speicherelement (9) zu empfangen, und daß der JTAG-Schnittstellen-Controller (2) dafür ausgelegt ist, das nichtflüchtige Speicherelement (9) zu steuern.

7. Integrierte Schaltung nach Anspruch 5, **dadurch gekennzeichnet, daß** der erste Schalter (8) dafür ausgelegt ist, das JTAG-Freigabesignal (B) aus einer zu der integrierten Schaltung gehörenden elektrischen Schmelzsicherung (9') zu empfangen, und daß der JTAG-Schnittstellen-Controller (2) dafür ausgelegt ist, die elektrische Schmelzsicherung (9') durch Leiten eines Programmierstroms (C) durch sie zu programmieren.

8. Integrierte Schaltung nach einem der Ansprüche 5 bis 7, **dadurch gekennzeichnet, daß** der erste Schalter (8) dafür ausgelegt ist, einen neuen Zustand des JTAG-Freigabesignals (B) nur bei erneutem Einschalten der integrierten Schaltung zu lesen.

## Revendications

1. Procédé destiné à un circuit intégré comprenant une interface (1) de test de balayage JTAG, une unité (2) de commande d'interface JTAG et une première broche (3), la première broche (3) offrant la possibilité de commander l'utilisation de l'interface (1) JTAG via une entrée de commande afin que, lorsqu'un signal JTAG# sur la première broche (3) est dans un premier état, l'interface (1) JTAG soit connectée à un premier jeu de broches (41, 42, 43, 44) à des fins de test, et que, lorsque le signal JTAG# est dans un deuxième état, le premier jeu de broches (41, 42, 43, 44) soit disponible pour d'autres fonctions et d'autres buts (51, 52, 53, 54), **caractérisé par** le fait de :
- produire un signal de validation JTAG (B) commandé par l'unité (2) de commande d'interface JTAG,
- coupler la première broche (3) à l'unité de commande lorsque le signal de validation JTAG (B) est dans un premier état ; et
- découpler la première broche (3) de l'entrée de commande afin qu'elle soit disponible pour d'autres fonctions et dans d'autres buts (7) lorsque le signal de validation JTAG (B) est dans un deuxième état.

2. Procédé suivant la revendication 1, **caractérisé en ce que** le signal de validation JTAG (B) provient d'un élément (9) de mémorisation non volatil appartenant au circuit intégré et **en ce que** l'unité (2) de commande d'interface JTAG commande l'élément (9) de mémorisation non volatil.

3. Procédé suivant la revendication 1, **caractérisé en ce que** le signal de validation JTAG (B) est produit par un fusible (9') programmable électriquement appartenant au circuit intégré, et **en ce que** l'unité (2) de commande d'interface JTAG programme le fusible (9') programmable électriquement en y faisant passer un courant de programmation (C).

4. Procédé suivant l'une quelconque des revendications précédentes, **caractérisé en ce qu'**un nouvel état du signal de validation JTAG (B) n'est lu que lors d'une réinitialisation de mise sous tension.

5. Circuit intégré comprenant une interface (1) de test de balayage JTAG, une unité (2) de commande d'interface JTAG et une première broche (3), dans lequel il est possible de commander l'utilisation de l'interface (1) JTAG au moyen d'un signal JTAG# sur la première broche (3), dans lequel l'interface (1) JTAG est connectée à un premier jeu de broches (41, 42, 43, 44) à des fins de test si le signal JTAG# est dans un premier état, et dans lequel le premier jeu de broches (41, 42, 43, 44) est disponible pour d'autres fonctions et dans d'autres buts (51, 52, 53, 54) si le signal JTAG# est dans un deuxième état, **caractérisé en ce que** l'unité (2) de commande d'interface JTAG est configurée pour commander la production d'un signal de validation JTAG (B), **en ce qu'**un premier commutateur (8), appartenant au circuit intégré, est configuré pour commuter la connexion de la première broche (3) entre deux fonctions, **en ce que** le premier commutateur (8) est configuré pour connecter la première broche (3) de façon à commander l'utilisation de l'interface (1) JTAG lorsque le signal de validation JTAG (B) est dans un premier état, et **en ce que** le premier commutateur (8) est configuré pour connecter la première broche (3) afin qu'elle soit disponible pour d'autres fonctions et dans d'autres buts (7) lorsque le signal de validation JTAG (B) est dans un deuxième état.

6. Circuit intégré suivant la revendication 5, **caractérisé en ce que** le premier commutateur (8) est configuré pour recevoir le signal de validation JTAG (B) d'un élément (9) de mémorisation non volatil appartenant au circuit intégré et **en ce que** l'unité (2) de commande d'interface JTAG est configurée pour commander l'élément (9) de mémorisation non volatil.

7. Circuit intégré suivant la revendication 5, **caractérisé en ce que** le premier commutateur (8) est configuré pour recevoir le signal de validation JTAG (B) d'un fusible (9') programmable électriquement appartenant au circuit intégré, et **en ce que** l'unité (2) de commande d'interface JTAG est configurée pour programmer le fusible (9') programmable électriquement en faisant passer à travers lui un courant (C) de programmation.

8. Circuit intégré suivant l'une quelconque des revendications 5 à 7, **caractérisé en ce que** le premier commutateur (8) est configuré pour ne lire un nouvel état du signal de validation JTAG (B) que lors d'une réinitialisation de mise sous tension.
